(19) Europäisches Patentamt
European Patent Office
Office européen des brevets

(11) EP 2 629 372 A2

(12) **EUROPEAN PATENT APPLICATION**
published in accordance with Art. 153(4) EPC

(43) Date of publication:
21.08.2013 Bulletin 2013/34

(51) Int Cl.:
*H01R 4/66* (2006.01)          *H01R 43/00* (2006.01)
*C23F 13/00* (2006.01)

(21) Application number: 11832725.3

(22) Date of filing: 11.10.2011

(86) International application number:
PCT/KR2011/007519

(87) International publication number:
WO 2012/050338 (19.04.2012 Gazette 2012/16)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 11.10.2010 KR 20100098691

(71) Applicant: Omni LPS. Co., Ltd.
Seoul 150-946 (KR)

(72) Inventors:
• LEE, Kang Soo
Incheon 403-726 (KR)
• CHUNG, Young-ki
Seoul 150-040 (KR)

(74) Representative: Beck, Alexander
Hansmann & Vogeser
Patent- und Rechtsanwälte
Maximilianstrasse 4b
82319 Starnberg (DE)

(54) **APPARATUS AND METHOD FOR CALCULATING LENGTH OF CARBON GROUNDING ELECTRODE MODULE BASED ON TWO-LAYERED DISTRIBUTED CONSTANT CIRCUIT**

(57) The present invention relates to an apparatus and method for calculating a length of a carbon grounding electrode module, which calculates a grounding electrode module length with the smallest grounding impedance variation depending on frequency variation, with respect to the grounding electrode module having a co-axial structure and being filled therein with a carbon-containing filler, wherein the present invention comprises: configuring two distributed constant circuits into two layers to configure a grounding electrode circuit; receiving the resistivity and relative dielectric constant of ground, the resistivity and relative dielectric constant of the filler, and the inside and outside diameters of the grounding electrode module, as dummy variables; selecting a plurality of frequencies within a frequency variation range; simulating a grounding electrode circuit with the dummy variables with respect to each selected frequency to calculate grounding impedances corresponding to lengths of a grounding electrode; and obtaining the grounding electrode length that is the minimum difference between the grounding impedances of respective frequencies. Through this, a grounding electrode module is implemented in which the variation of a grounding impedance is small even during frequency variations, thereby making it possible to develop a grounding system having a stable performance even with high-frequency fault currents, such as stroke currents or the like.

[FIG. 2]

**Description**

[Technical Field]

The present invention relates to an apparatus and method for calculating a length of a grounding electrode module, which calculates a length of a grounding electrode module, which has a coaxial structure and is filled with a carbon-containing filler, at which the variation of grounding impedance depending on frequency variation is minimized.

In particular, the present invention relates to an apparatus and method for calculating a length of a grounding electrode module, in which two distributed constant circuits are configured in two layers such that an upper distributed constant circuit reflects the properties of a filler and a lower distributed constant circuit reflects the properties of the ground.

Moreover, the present invention relates to an apparatus and method for calculating a length of a grounding electrode module, which simulates a grounding impedance corresponding to the length of the grounding electrode for each frequency within a predetermined frequency range with a two-layered distributed constant circuit and calculates a length of the grounding electrode module, at which the difference in grounding impedance at each frequency is minimized.

[Background Art]

Recently, the Korean industry has rapidly accepted international standards as domestic standards to occupy the international market as well as the domestic market and to remain competitive depending on the internationalization. With respect to the regulations regarding grounding in Korea, international standards for grounding, such as IEC 60364, IEC 62305, etc., have been accepted without any changes and converted to domestic industrial standards in the field of building electrical and in the field of lightning protection and grounding, and new standards including wiring regulations and various standards for grounding have been revised.

Among the key points of the revised rules, the rules on grounding prohibit the use of construction methods or chemical additives that cause environmental pollution and force the utilization of equipotential common groundings in which all groundings for electric power facilities , communication systems, lightning protection systems, etc. are used as a single grounding electrode.

It can be said that these grounding systems are very effective grounding systems in environments, such as general buildings, houses, apartments, etc., where there is little or no high-frequency noise. However, fault currents occur in the form of high frequencies in information and communication buildings in which high-speed semiconductor switching devices such as UPS equipment are used, or in areas with high lightning incidence, and thus the increase in grounding impedance due to the high frequencies is several times to several tens of times even with the use of common groundings. As a result, a very high potential rise occurs even with the same fault current (including lightning), which may have very serious adverse effects on electronic components and equipment.

However, even under the modified standards as well as the existing standards for grounding, the design and testing of grounding systems are made mainly based on grounding resistance regardless of the use of buildings, and during calculation of safety voltage such as touch voltage, step voltage, etc., only power frequency fault current is contemplated. In order to design and build a grounding system, it is necessary to consider the lightning current and the high-frequency voltage noise, which may occur in high-frequency equipment, as well as the power frequency fault current. The lightning current and the fault current occurring in high-frequency equipment have high frequencies, and thus it is necessary to design and build the grounding system in view of grounding impedance.

At present, most designers and builders of grounding systems in Korea increase the size of grounding electrodes based only on the grounding resistance and install long underground wires or long vertical grounding electrodes by drilling the ground. Most of these large grounding electrodes exhibit rapidly increasing grounding impedance at high frequencies, which create conditions that cannot ensure the safety of equipment and human body against high-frequency fault currents

Accordingly, a design technique that can maintain the grounding resistance that is obtained at low frequencies when a high-frequency fault current is applied to a grounding electrode is required, and the development of a grounding electrode with the smallest grounding impedance variation, which replaces the existing grounding electrodes and carbon grounding electrodes, is required.

When a current flowing through a grounding electrode is in the power frequency range, the entire grounding electrode functions as the grounding electrode. However, in the case of grounding current with high-frequency components, such as lightning stroke current, only a part of a grounding electrode conductor functions as the grounding electrode. The reason that only a part of the grounding electrode conductor functions as the grounding electrode is that the grounding impedance increases rapidly when viewed from a different point and it is technically impossible to analyze its properties with the grounding resistance in a normal state.

Accordingly, in order to effectively perform the protective operation of the grounding system, it is necessary to develop a grounding electrode that is more effective at high frequencies, to arrange the grounding electrode in view of grounding impedance, and design and build the grounding electrode in view of its effective length. Moreover, the high frequency characteristics depend on the type of grounding electrode, and even the grounding electrodes having the same grounding resistance in the power frequency range exhibit different transient response characteristics.

At present, in most grounding systems for distribution systems, overhead ground wires, other cross arms, and neutral conductors of low-voltage distribution lines are connected in the form of multiple grounds. Accordingly, when a lightning overvoltage reaching one point is not effectively protected, the lightning overvoltage propagates toward the other point, and the frequency of accidents due to direct lightning and induced lightning is very high over the entire grounding system for distribution system. The performance of the grounding system for distribution system is evaluated based on the grounding resistance and the system is designed based on the grounding resistance. As a result, during lightning current flow, a grounding potential rise which is higher than a designed value may occur frequently.

Accordingly, a method for evaluating the performance of the grounding system in terms of the grounding impedance is required, and when the design is based on the frequency dependence of grounding impedance, it is possible to provide more effectively protection.

Meanwhile, as the performance of the grounding system is simply defined as grounding resistance values in accordance with electrical equipment technical standards, only the grounding resistance value is considered as being important. However, the importance of the grounding system has recently been emphasized, and it is necessary to consider the grounding impedance including a transient state as well as the grounding resistance in a normal state.

The consideration in terms of the grounding impedance is very important for lightning protection in a distribution system, in which the dielectric strength of devices or equipment is significantly lower than that of a power transmission line. Since the lightning current propagates at a high speed with a rapid rise time, it may cause extensive damage to consumers connected to a low-voltage distribution system. Accordingly, the development of a performance evaluation technique in terms of the grounding impedance and a design technique in the grounding system for distribution system, and the experimental research depending on the types of grounding electrodes and down-conductors used in the distribution system are the important fields that cannot be ignored any more.

As the importance of the grounding equipment and the interest in the grounding system have recently increased, the scale of related industries has gradually increased all over the world. While the grounding was done using grounding copper rods and copper plates in the past, various grounding electrodes are developed and built in various ways at present. The grounding system-related technologies in Korea are divided into electrolytic grounding rods and chemical grounding resistance-reducing agents as foreign products, used in poor environments such as mountains, rocks, etc., and needle-shaped grounding electrodes and carbon grounding rods developed in Korea.

Grounding electrodes used in foreign countries mainly include grounding copper rods, stainless rods, and electrolytic grounding modules. Among them, the grounding copper rods and the electrolytic grounding rods have the problems such as corrosion and soil pollution and thus tend to be replaced with stainless rods and carbon rods.

At present, designs in terms of only the grounding resistance for each classification such as existing electric power, communication, lightning protection, etc. are mainly dominated in Korea, and due to the internationalization of related regulations, some grounding systems, which employ common groundings using a grounding design program, have recently been designed as a transition period of grounding system design.

In the design of the grounding system, the grounding design in terms of the grounding impedance depending on the frequency characteristics of fault current is not fulfilled. Actually, almost all of the design engineering companies design the groundings as the existing groundings for each classification or design the grounding systems with assistance of lightning protection grounding companies. Accordingly, the designs in terms of the grounding impedance depending on the frequency characteristics are unsatisfactory.

Foreign grounding design technologies mainly include designs in terms of safety voltage (step and touch voltages), rather than the grounding resistance and almost all of equipments and buildings tend to be equipped with grounding systems in terms of safety voltage in foreign countries. Despite these trends, the grounding system design in terms of the grounding impedance depending on the frequency characteristics has not yet developed.

[Disclosure]

[Technical Problem]

Accordingly, the present invention has been made to solve the above-described problems, and an object of the present invention is to provide an apparatus and method for calculating a length of a carbon grounding electrode module, which calculates a length of a grounding electrode module, which has a coaxial structure and is filled with a carbon-containing filler, at which the variation of grounding impedance depending on frequency variation is minimized.

Moreover, another object of the present invention is to provide an apparatus and method for calculating a length of a carbon grounding electrode module, which performs a simulation using a distributed constant circuit model to reflect the properties of the ground and filler whose impedances are changed at a high frequency.

[Technical Solution]

To achieve the above objects, an aspect of the present invention provides an apparatus for calculating a length of a carbon grounding electrode module, which has a coaxial structure and is filled with a carbon-containing filler, at which the variation of grounding impedance depending on frequency variation is minimized, the apparatus comprising: a circuit configuration unit which configures a two-layered grounding electrode circuit with two distributed constant circuits; a parameter input unit which receives resistivity and relative dielectric constant of ground, resistivity and relative dielectric constant of a filler, and internal and external diameters of the grounding electrode module as simulation parameters; a frequency selection unit which selects a plurality of frequencies within a frequency variation range; a simulation unit which calculates a grounding impedance corresponding to a length of the grounding electrode by simulating the grounding electrode circuit with the simulation parameters with respect to each of the selected frequencies; and a grounding length estimation unit which obtains a length of the grounding electrode at which the difference between a maximum value and a minimum value of the grounding impedance at each frequency is minimized.

Moreover, in the apparatus for calculating the length of the carbon grounding electrode module according to the present invention, the grounding electrode circuit is a two-layered grounding electrode circuit that comprises a lower distributed constant circuit using the resistivity and relative dielectric constant of the ground and an upper distributed constant circuit using the resistivity and relative dielectric constant of the filler.

Furthermore, in the apparatus for calculating the length of the carbon grounding electrode module according to the present invention, the two-layered grounding electrode circuit comprises $\mu$-type unit circuits in two layers, each of the $\mu$-type unit circuits configuring a parallel circuit of conductance G and capacitance C on both sides and connecting the parallel circuit on both sides to a circuit of inductance L.

In addition, in the apparatus for calculating the length of the carbon grounding electrode module according to the present invention, a first conductance $G_1$, a first capacitance $C_1$, and a first inductance $L_1$ of the upper distributed constant circuit and a second conductance $G_2$, a second capacitance $C_2$, and a second inductance $L_2$ of the lower distributed constant circuit are calculated during vertical burial by Equation 1:

[Equation 1]

$$G_1 = \frac{2\pi}{\rho_1 \ln\left(\frac{4l}{d_1}\right)} \quad [\mho/m]. \quad G_2 = \frac{2\pi}{\rho_2 \ln\left(\frac{4l}{d_2}\right)} \quad [\mho/m].$$

$$C_1 = \frac{2\pi\epsilon_1\epsilon_0}{\ln\left(\frac{4l}{d_1}\right)} \quad [F/m]. \quad C_2 = \frac{2\pi\epsilon_2\epsilon_0}{\ln\left(\frac{4l}{d_2}\right)} \quad [F/m].$$

$$L_1 = \frac{\mu_0}{2\pi} \ln\left(\frac{4l}{d_1}\right) \quad [H/m]. \quad L_2 = \frac{\mu_0}{2\pi} \ln\left(\frac{4l}{d_2}\right) \quad [H/m].$$

wherein $l$, $d_1$, and $d_2$ represent the length, internal diameter, and external diameter of the grounding electrode module, respectively, $\rho_1$ and $\epsilon_1$ represent the resistivity and relative dielectric constant of a filler, respectively, $\rho_2$ and $\epsilon_2$ represent the resistivity and relative dielectric constant of ground, respectively, and $\epsilon_0$ and $\mu_0$ represent the permittivity and permeability of vacuum, respectively.

Additionally, in the apparatus for calculating the length of the carbon grounding electrode module according to the present invention, a first conductance $G_1$, a first capacitance $C_1$, and a first inductance $L_1$ of the upper distributed constant circuit and a second conductance $G_2$, a second capacitance $C_2$, and a second inductance $L_2$ of the lower distributed constant circuit are calculated during horizontal burial by Equation 2:

[Equation 2]

$$G_1 = \frac{\pi}{\rho_1} \frac{1}{\ln\left(\frac{2l}{\sqrt{2r_1 s}}\right) - 1} \ [\mho/m], \quad G_2 = \frac{\pi}{\rho_2} \frac{1}{\ln\left(\frac{2l}{\sqrt{2r_2 s}}\right) - 1} \ [\mho/m],$$

$$C_1 = \frac{\pi\epsilon_1\epsilon_0}{\ln\left(\frac{2l}{\sqrt{2r_1 s}}\right) - 1} \ [F/m], \quad C_2 = \frac{\pi\epsilon_2\epsilon_0}{\ln\left(\frac{2l}{\sqrt{2r_2 s}}\right) - 1} \ [F/m],$$

$$L_1 = \frac{\mu_0}{\pi}\ln\left(\frac{2l}{\sqrt{2r_1 s}}\right) - 1 \ [H/m], \quad L_2 = \frac{\mu_0}{\pi}\ln\left(\frac{2l}{\sqrt{2r_2 s}}\right) - 1 \ [H/m].$$

wherein 1, $d_1$, and $d_2$ represent the length, internal diameter, and external diameter of the grounding electrode module, respectively, $\rho_1$ and $\varepsilon_1$ represent the resistivity and relative dielectric constant of a filler, respectively, $\rho_2$ and $\varepsilon_2$ represent the resistivity and relative dielectric constant of ground, respectively, $\varepsilon_0$ and $\mu_0$ represent the permittivity and permeability of vacuum, respectively, and s represents the burial depth.

Moreover, in the apparatus for calculating the length of the carbon grounding electrode module according to the present invention, the simulation unit performs the simulation using an EMTP program.

Furthermore, in the apparatus for calculating the length of the carbon grounding electrode module according to the present invention, the grounding length estimation unit divides the length of the grounding electrode module by a unit length, obtains a difference between a maximum value and a minimum value of the grounding impedance at each frequency corresponding to each length of the grounding electrode module (hereinafter, referred to as an impedance variation range for each length), and determines the length of the grounding electrode module at which the impedance variation range for each length is the smallest.

Moreover, another aspect of the present invention provides a method for calculating a length of a carbon grounding electrode module, which has a coaxial structure and is filled with a carbon-containing filler, at which the variation of grounding impedance depending on frequency variation is minimized, the method comprising the steps of: (a) configuring a two-layered grounding electrode circuit with two distributed constant circuits; receiving resistivity and relative dielectric constant of ground, resistivity and relative dielectric constant of a filler, and internal and external diameters of the grounding electrode module as simulation parameters; (c) selecting a plurality of frequencies within a frequency variation range; (d) calculating a grounding impedance corresponding to a length of the grounding electrode by simulating the grounding electrode circuit with the simulation parameters with respect to each of the selected frequencies; and (e) obtaining a length of the grounding electrode at which the difference between a maximum value and a minimum value of the grounding impedance at each frequency is minimized.

Furthermore, the present invention provides a computer-readable recoding medium in which a program executing the above-described method is recorded.

[Advantageous Effects]

As described above, according to the apparatus and method for calculating the length of the grounding electrode module in accordance with the present invention, the grounding electrode module in which the grounding impedance variation is small even during the frequency variation can be implemented, which thus makes it possible to develop a grounding system having a stable performance even with respect to high-frequency fault currents such as lightning stroke currents.

In particular, according to the apparatus and method for calculating the length of the grounding electrode module in accordance with the present invention, the properties of the ground and filler, whose impedances are changed at a high frequency, are reflected on the simulation, which thus makes it possible to design a grounding system suitable for various ground conditions or frequency conditions.

[Description of Drawings]

FIG. 1 is a diagram showing an example of the configuration of the entire system for implementing the present invention.

FIG. 2 is a block diagram showing the configuration of an apparatus for calculating a length of a carbon grounding electrode module in accordance with one embodiment of the present invention.

FIG. 3 is a diagram showing the distribution characteristics of a current flowing into a grounding electrode and an equivalent circuit of a distributed constant circuit model.

FIG. 4 is a diagram showing a two-layered distributed constant circuit model of a carbon grounding electrode module in accordance with one embodiment of the present invention.

FIG. 5 is a circuit diagram of unit distributed constant circuits of a two-layered distributed constant circuit in accordance with one embodiment of the present invention.

FIG. 6 is a graph showing the resistivity and relative dielectric constant of a filler depending on the carbon content in accordance with one embodiment of the present invention.

FIG. 7 is a graph showing the simulation results of grounding impedances depending on the frequency during vertical burial of a 10 m carbon grounding electrode module in accordance with one embodiment of the present invention.

FIG. 8 is a graph showing the simulation results of grounding impedances of a carbon grounding electrode module in accordance with one embodiment of the present invention.

FIG. 9 is a graph showing the simulation and measured results of the frequency dependence on grounding impedances of a carbon grounding electrode module in accordance with one embodiment of the present invention.

FIG. 10 is a table showing optimum design lengths of a coaxial carbon grounding electrode module with a minimum grounding impedance variation depending on the frequency in accordance with one embodiment of the present invention.

FIG. 11 is a diagram showing the calculation of a magnetic field strength depending on a current flowing through a grounding conductor in accordance with one embodiment of the present invention.

FIG. 12 is a table showing the measurement and simulation results of the inductance of grounding conductors in accordance with one embodiment of the present invention.

FIG. 13 shows frequency-impedance graphs based on the effect of a grounding conductor (down-conductor) in accordance with one embodiment of the present invention.

FIG. 14 is a flowchart showing a method for calculating a length of a carbon grounding electrode module in accordance with one embodiment of the present invention.

[Mode for Invention]

Hereinafter, preferred embodiments for implementing the present invention will be described with reference to the accompanying drawings. Moreover, in describing the present invention, the same elements are denoted by the same reference numerals, and a repetitive description thereof will be omitted.

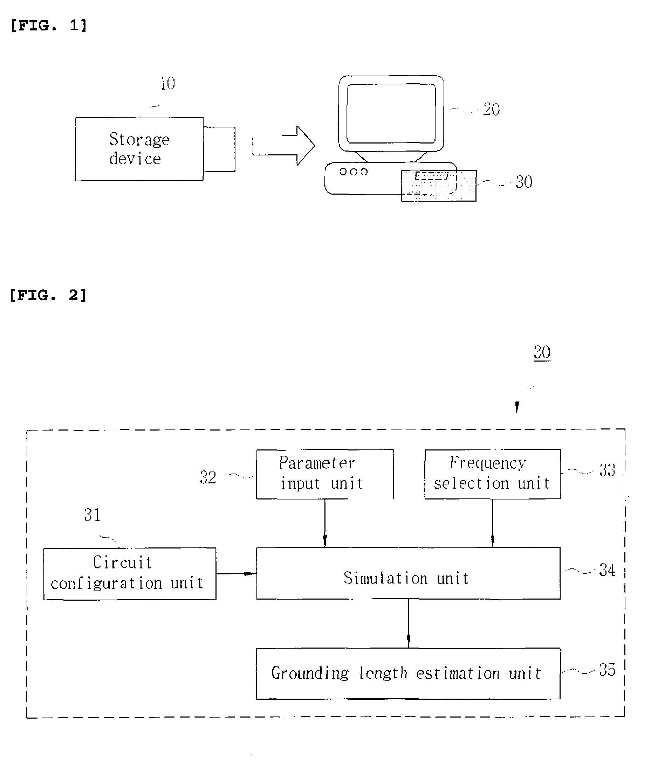

First, examples of the configuration of the entire system for implementing the present invention will be described with reference to FIG. 1.

As shown in FIG. 1, an apparatus and method for calculating a length of a grounding electrode module according to the present invention may be implemented as a device on a computer terminal 20 or a program system 30 which receives and processes simulation parameters stored in a storage device 10.

That is, the apparatus and method for calculating the length of the electrode module is configured as a program and installed to run on the computer terminal 20. The program installed in the computer terminal 20 can operate together with a single device or system 30.

Moreover, the computer terminal 20 is a terminal device having a computing function such as a PC, notebook, PDA, smartphone, etc. meanwhile, as another embodiment, the apparatus and method for calculating the length of the electrode module may be implemented as a single electronic circuit such as an application-specific integrated circuit (ASIC). The apparatus and method for calculating the length of the electrode module may be implemented as other possible forms.

The storage device 10 is a data storage storing simulation parameters and includes a database (or DB server) on a network, a storage space such as a hard disk of the computer terminal 20, a portable storage medium, etc. Moreover, as another embodiment, the simulation parameters may be directly input to the computer terminal 20 by an analyzer.

Next, the configuration of an apparatus for calculating a length of a carbon grounding electrode module in accordance with one embodiment of the present invention will be described with reference to FIG. 2.

As shown in FIG. 2, an apparatus 30 for calculating a length of an electrode module comprises a circuit configuration unit 31, a parameter input unit 32, a frequency selection unit 33, a simulation unit 34, and a grounding length estimation unit 35.

The circuit configuration unit 31 configures a two-layered grounding electrode circuit with two distributed constant circuits. The grounding electrode circuit is a two-layered grounding electrode circuit that comprises a lower distributed constant circuit using resistivity and relative dielectric constant of ground and an upper distributed constant circuit using resistivity and relative dielectric constant of a filler.

When a lightning current with high-frequency components and a high-frequency fault current causing electromagnetic interference (EMI) are applied to a grounding electrode, impedance characteristics due to the inductance of the grounding electrode and the capacitance of the soil occur, and the impedance characteristics for these high-frequency currents can be interpreted using a distributed constant circuit model. When a surge or fault current flows into the grounding electrode, it is discharged to the ground in the form of leakage current distributed along the buried grounding electrode. The distribution characteristics of these currents may be theoretically implemented using a transmission line theory, and a simulation analysis method implementing the same is the distributed constant circuit model used in the present invention.

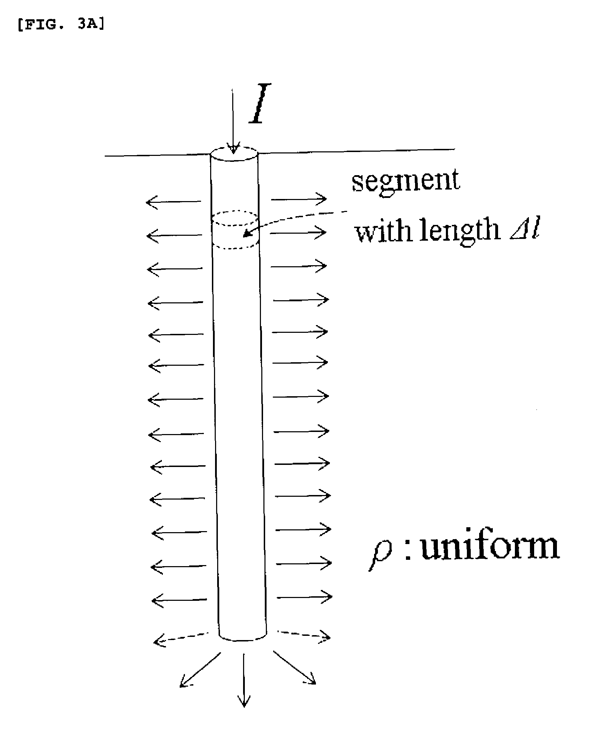

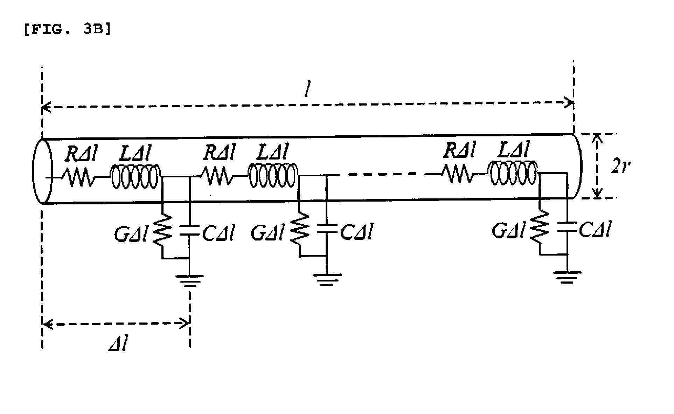

The distributed constant circuit model represents the resistance R and inductance L of copper, a metal conductor forming the grounding electrode, and the conductance G and capacitance C of soil, in which the grounding electrode is buried, as distributed circuit constants, as shown in FIG. 3B, and calculates the grounding impedance of the grounding electrode using the distributed circuit constants and the wave equation for the transmission line.

The resistivity of the soil in which the grounding electrode is buried is 1 to $10^6$ $\Omega$m, which is $10^8$ to $10^{14}$ times the resistivity $10^{-8}$ $\Omega$m of the copper forming the grounding electrode. Thus, the resistance R of the grounding electrode itself can be ignored during design of the grounding system, and only the inductance component is reflected in the model on the assumption that grounding electrode is an ideal conductor.

The simulation of a coaxial carbon grounding electrode module performed in the present invention adds the properties of the carbon grounding electrode module to a simulation method of a distributed constant circuit model of a linear grounding electrode.

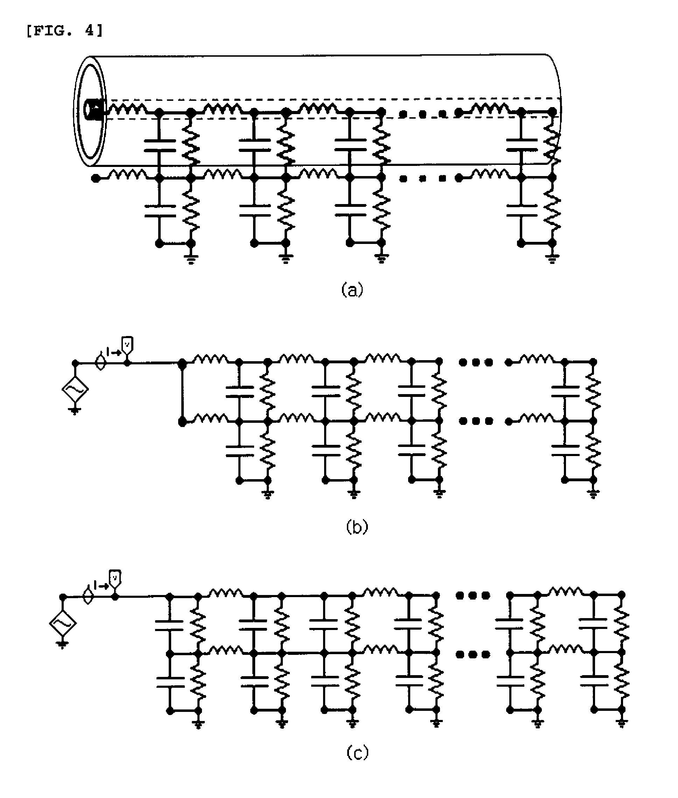

The carbon grounding electrode module is a kind of linear grounding electrode and can be simulated on the grounding impedance. However, the properties of the carbon inside the carbon grounding electrode module affect the grounding impedance depending on the frequency, and thus a simulation model with a two-layered distributed constant circuit is used as shown in FIG. 4A.

FIG. 4A shows a two-layered distributed constant circuit model for the simulation of the coaxial carbon grounding electrode module. The simulation model of the carbon grounding electrode module comprises an upper distributed constant circuit for reflecting the properties of carbon and a lower distributed constant circuit for reflecting the properties of soil.

While the lower distributed constant circuit can calculate the distributed circuit constants in the same manner as the existing distributed constant circuits, the upper distributed constant circuit considers the resistivity and relative dielectric constant, which vary depending on the frequency and carbon content, to reflect the properties of the filler and carbon.

The resistivity and relative dielectric constant of the filler vary depending on the carbon content. Particularly, the relative dielectric constant significantly varies depending on the frequency. By reflecting the carbon content and frequency dependence of the filler, it is possible to provide a two-layered distributed constant circuit model that can more clearly reflect the structural characteristics of the grounding electrode itself that the existing distributed constant circuit models.

FIGS. 4B and 4C show two-layered distributed constant circuit models improved from the distributed constant circuit models for the existing grounding electrodes. In the case of the two-layered distributed constant circuit model in FIG. 4B, the properties of the filler are not considered at an application point but shorted, and thus, as shown in FIG. 4C, the distributed constant circuit model is improved by employing a $\pi$-type model such that the properties of the filler can be reflected at the application point.

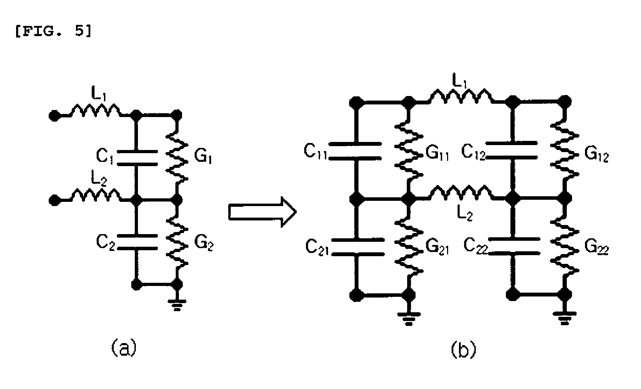

Since the two-layered distributed constant circuit model is generally composed of the upper distributed constant circuit for reflecting the properties of the filler and the lower distributed constant circuit for reflecting the properties of the soil (or ground), the simulation is possible when each distributed constant circuit is calculated. As shown in FIG. 5, the distributed circuit constants can be calculated by calculating the distributed circuit constants of the two-layered distributed constant circuit model and then modifying the distributed circuit constants to fit the $\pi$-type two-layered distributed constant circuit model.

As can be seen from FIG. 5, n-type unit circuits of the $\pi$-type two-layered distributed constant circuit are configured in two layers. The upper n-type unit circuit configures a parallel circuit of conductance G and capacitance C on both sides and connects the parallel circuit on both sides to a circuit of inductance $L_1$. That is, the parallel circuit (hereinafter, a first upper parallel circuit) of a first upper conductance $G_{11}$ and a first upper capacitance $C_{11}$ and the parallel circuit (hereinafter, a second upper parallel circuit) of a second upper conductance $G_{12}$ and a second upper

capacitance $C_{12}$ are configured on both sides. Then, both ends of the upper inductance $L_1$ are connected to one end of the first upper parallel circuit and one end of the second upper parallel circuit, respectively.

In the same manner as the upper π-type unit circuit, the lower π-type unit circuit configures a parallel circuit of conductance G and capacitance C on both sides and connects the parallel circuit on both sides to a circuit of inductance $L_2$. That is, the parallel circuit (hereinafter, a first lower parallel circuit) of a first lower conductance $G_{21}$ and a first upper capacitance $C_{21}$ and the parallel circuit (hereinafter, a second lower parallel circuit) of a second lower conductance $G_{22}$ and a second lower capacitance $C_{22}$ are configured on both sides. Then, both ends of the lower inductance $L_2$ are connected to one end of the first lower parallel circuit and one end of the second lower parallel circuit, respectively.

The upper π-type unit circuit and the lower π-type unit circuit connect the parallel circuits, respectively. That is, one end of the first upper parallel circuit is connected to one end of the first lower parallel circuit. Here, the other end of the first upper parallel circuit, which is not connected to the one end of the upper inductance $L_1$, is connected to the one end of the first lower parallel circuit, which is connected to the one end of the lower inductance $L_2$.

In the same manner, the other end of the second upper parallel circuit, which is not connected to the one end of the upper inductance $L_1$, is connected to the one end of the second lower parallel circuit, which is connected to the one end of the lower inductance $L_2$.

First, the lower distributed constant circuit model will be described.

Distributed circuit constants $G_2$, $C_2$, and $L_2$ of the lower circuit may be calculated with a grounding resistance $R_0$ due to an external electrode in the same manner as the existing linear grounding electrodes. The grounding resistance $R_0$ is determined by the ground resistivity of soil around the grounding electrode. The grounding resistance $R_0$ is calculated using a grounding resistance formula of a vertical grounding electrode in Equation 3 during vertical burial of the coaxial carbon grounding electrode module and using a grounding resistance formula of an underground wire in Equation 7 during horizontal burial. In the distributed constant circuit model, the conductance per unit length due to soil is a circuit constant related to the grounding resistance and is calculated by dividing the reciprocal of the grounding resistance by a length of the grounding electrode.

According to the transmission line theory, distributed circuit constants G, C, and L have the relationship represented by Equations 1 and 2.

[Equation 1]

$$C/G = \epsilon_2 \epsilon_0 \rho$$

[Equation 2]

$$LC = \mu_0 \epsilon_2 \epsilon_0$$

Here, $\epsilon_2$ represents the relative dielectric constant of soil, and $\epsilon_0$ and $\pi_0$ represent the permittivity and permeability of vacuum, respectively.

C and L may be calculated using G calculated by dividing the reciprocal of the grounding resistance by a length of the grounding electrode from the relationship between G, C, and L.

The grounding resistance formula for the vertical grounding electrode used during vertical burial of the coaxial carbon grounding electrode module is as shown in Equation 3, and the distributed circuit constancies of the coaxial carbon grounding electrode module are calculated as shown in Equations 4 to 6.

[Equation 3]

$$R_0 = \frac{\rho_2 \ln\left(\frac{4l}{d_2}\right)}{2\pi l} \quad [\Omega]$$

[Equation 4]

$$G_2 = \frac{1}{R_0}\frac{1}{l} = \frac{2\pi}{\rho_2 \ln\left(\dfrac{4l}{d_2}\right)} \quad [\mho/\mathrm{m}]$$

[Equation 5]

$$C_2 = \frac{2\pi\epsilon_2\epsilon_0}{\ln\left(\dfrac{4l}{d_2}\right)} \quad [\mathrm{F/m}]$$

[Equation 6]

$$L_2 = \frac{\mu_0}{2\pi}\ln\left(\frac{4l}{d_2}\right) \quad [\mathrm{H/m}]$$

Here, 1 represents the length of the coaxial carbon grounding electrode module, $d_2$ represents the diameter of an external conductor of the coaxial carbon grounding electrode module, $\rho_2$ represents the resistivity of the ground, $\varepsilon_2$ represents the relative dielectric constant of the ground, and $\varepsilon_0$ and $\pi_0$ represent the permittivity and permeability of vacuum, respectively.

The grounding resistance formula for the underground wire used during horizontal burial of the coaxial carbon grounding electrode module is as shown in Equation 7, and the unit distributed constant circuits of the coaxial carbon grounding electrode module are calculated as shown in Equations 8 to 10.

[Equation 7]

$$R_0 = \frac{\rho_2}{\pi l}\left[\ln\left(\frac{2l}{\sqrt{2r_2 s}}\right) - 1\right] \quad [\Omega]$$

[Equation 8]

$$G_2 = \frac{\pi}{\rho_2}\frac{1}{\ln\left(\dfrac{2l}{\sqrt{2r_2 s}}\right) - 1} \quad [\mho/\mathrm{m}]$$

[Equation 9]

$$C_2 = \frac{\pi \epsilon_2 \epsilon_0}{\ln\left(\dfrac{2l}{\sqrt{2r_2 s}}\right) - 1} \; [\text{F/m}]$$

[Equation 10]

$$L_2 = \frac{\mu_0}{\pi} ln\left(\frac{2l}{\sqrt{2r_2 s}}\right) - 1 \; [\text{H/m}]$$

Here, I represents the length of the coaxial carbon grounding electrode module, $r_2$ represents the radius of an external conductor of the coaxial carbon grounding electrode module, and s represents the burial depth.

The relative dielectric constant of the ground is very difficult to measure and its value varies depending on the content and resistivity of water. Accordingly, the simulation was performed by applying a single relative dielectric constant shown in various literatures. The simulation analysis was performed on the relative dielectric constant in the range of 10 to 80 by considering that the relative dielectric constant of dry soil is about 2 to 3 and the relative dielectric constant of water is about 80.

Next, the upper distributed constant circuit model will be described.

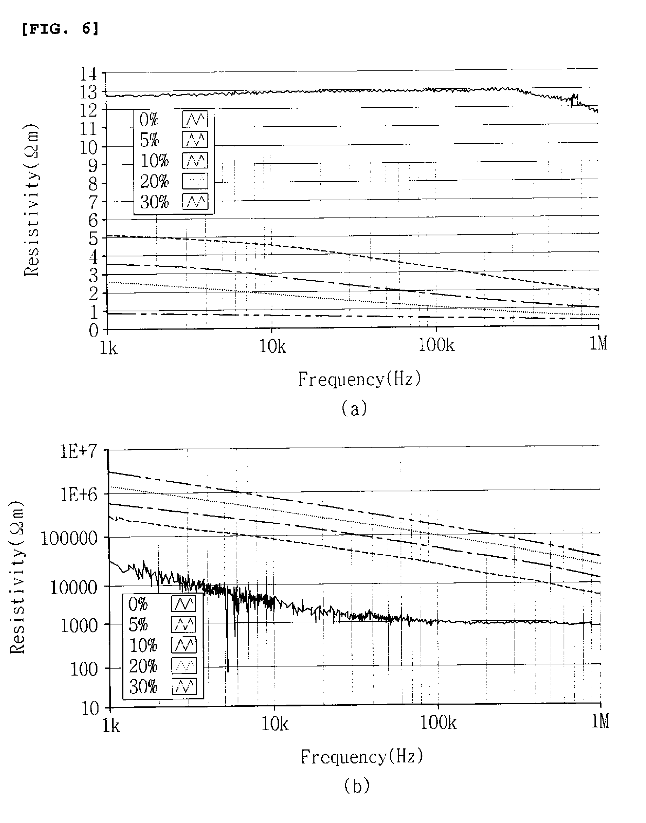

The distributed circuit constants of the upper circuit are parameters for simulating the filler, and these parameters are different from those of the soil (or ground), and thus the resistivity and relative dielectric constant of the filler depending on the carbon content were reflected in the simulation. FIG. 6 shows the resistivity and relative dielectric constant of the filler depending on the carbon content measured from 1 kHz to 1 MHz. While the resistivity of the filler decreased depending on the carbon content, the relative dielectric constant increased depending on the carbon content, and both parameters tend to increase as the frequency increases. Accordingly, the resistivity and relative dielectric constant of the filler were applied to the calculation of the distributed circuit constants $G_1$ and $C_1$ of the upper circuit in accordance with the frequencies corresponding to the simulation of the grounding impedance based on the above results.

The distributed circuit constants of the upper circuit used during vertical burial of the coaxial carbon grounding electrode module are calculated as shown in Equations 11 to 13.

[Equation 11]

$$G_1 = \frac{2\pi}{\rho_1 \ln\left(\dfrac{4l}{d_1}\right)} \; [\text{U/m}]$$

[Equation 12]

$$C_1 = \frac{2\pi \epsilon_1 \epsilon_0}{\ln\left(\dfrac{4l}{d_1}\right)} \; [\text{F/m}]$$

[Equation 13]

$$L_1 = \frac{\mu_0}{2\pi} \ln\left(\frac{4l}{d_1}\right) \; [\text{H/m}]$$

Here, 1 represents the length of the coaxial carbon grounding electrode module, $d_1$ represents the diameter of an internal conductor of the coaxial carbon grounding electrode module, $\rho_1$ represents the resistivity of the filler in the coaxial carbon grounding electrode module, $\varepsilon_1$ represents the relative dielectric constant of the filler in the coaxial carbon grounding electrode module, and $\varepsilon_0$ and $\pi_0$ represent the permittivity and permeability of vacuum, respectively.

The distributed circuit constants of the upper circuit used during horizontal burial of the coaxial carbon grounding electrode module are calculated as shown in Equations 14 to 16.

[Equation 14]

$$G_1 = \frac{\pi}{\rho_1} \frac{1}{\ln\left(\frac{2l}{\sqrt{2r_1 s}}\right) - 1} \; [\text{U/m}]$$

[Equation 15]

$$C_1 = \frac{\pi \epsilon_1 \epsilon_0}{\ln\left(\frac{2l}{\sqrt{2r_1 s}}\right) - 1} \; [\text{F/m}]$$

[Equation 16]

$$L_1 = \frac{\mu_0}{\pi} ln\left(\frac{2l}{\sqrt{2r_1 s}}\right) - 1 \; [\text{H/m}]$$

Here, 1 represents the length of the coaxial carbon grounding electrode module, $r_1$ represents the radius of an internal conductor of the coaxial carbon grounding electrode module, and s represents the burial depth.

Next, the parameter input unit 32 receives the resistivity and relative dielectric constant of the ground, the resistivity and relative dielectric constant of the filler, and the internal and external diameters of the grounding electrode module as the simulation parameters. That is, the parameter input unit 32 receives the internal and external diameters $d_1$ and $d_2$ of the grounding electrode module, the resistivity and relative dielectric constant $\rho_1$ and $\varepsilon_1$ of the filler, and the resistivity and relative dielectric constant $\rho_2$ and $\varepsilon_2$ of the ground as the simulation parameters described above.

Moreover, the frequency selection unit 33 selects a plurality of frequencies within a frequency variation range.

In the previous example, the frequency variation range is from 100 Hz to 1 MHz. The frequency selection unit 33 selects a plurality of frequencies representing the frequency variation range. For example, 100 Hz, 1 kHz, 10 kHz, 50 kHz, 100 kHz, 500 kHz, 1 MHz may be selected.

These frequency values may be selected in advance and stored. Otherwise, if a frequency variation range is given, a plurality of frequencies at regular intervals may be selected. Here, it is preferable that the regular intervals be log values obtained by taking the log of each frequency. Alternatively, as another example, the plurality of frequencies may be selected by increasing the frequency at a constant ratio.

Moreover, preferably, the plurality of frequencies may be selected by including a minimum frequency and a maximum frequency in the frequency variation range.

Next, the simulation unit 34 calculates the grounding impedance corresponding to the length of the grounding electrode by simulating the grounding electrode circuit with the simulation parameters with respect to each of the selected frequencies. Preferably, the simulation unit 34 performs the simulation using an EMTP program.

That is, the simulation of the grounding impedance at each frequency can be made using the EMTP program after calculating the distributed circuit constants of the upper and lower circuits and substituting the distributed circuit constants into the model of the coaxial carbon grounding electrode module.

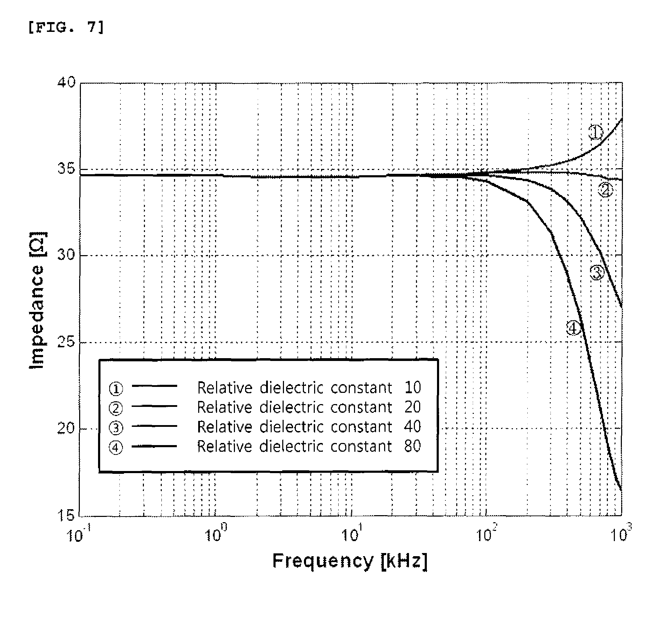

FIG. 7 shows an example of the simulation results of grounding impedances in the frequency range of 100 Hz to 1 MHz at a ground resistivity of 300 Ωm with respect to a 10 m carbon grounding electrode module. At frequencies below about 50 kHz, the grounding electrode module exhibited the grounding impedance close to the grounding resistance of the carbon grounding electrode module regardless of the magnitude of the relative dielectric constant. At frequencies above about 100 kHz, the grounding electrode module exhibited inductive characteristics in which the grounding impedance is greater than the grounding resistance or capacitive characteristics in which the grounding impedance is smaller than the grounding resistance. The characteristics of the 10 m carbon grounding electrode module were simulated in which the grounding impedance was not changed according to the frequency variation at a ground resistivity of 300 Ωm and a relative dielectric constant of 20. Based on these results, it is possible to calculate an optimal length of the grounding electrode, which is the most important key element in the grounding design in which the variation of grounding impedance depending on frequency variation is minimized according to the present invention.

Next, the grounding length estimation unit 35 obtains a length of the grounding electrode at which the difference in grounding impedance at each frequency is minimized. The grounding length estimation unit 35 divides the length of the grounding electrode module by a unit length, obtains a difference between a maximum value and a minimum value of the grounding impedance at each frequency corresponding to each length of the grounding electrode module (hereinafter, referred to as an impedance variation range for each length), and determines the length of the grounding electrode module at which the impedance variation range for each length is the smallest.

The simulation with the input simulation parameters will be described using the two-layered distributed constant circuit model.

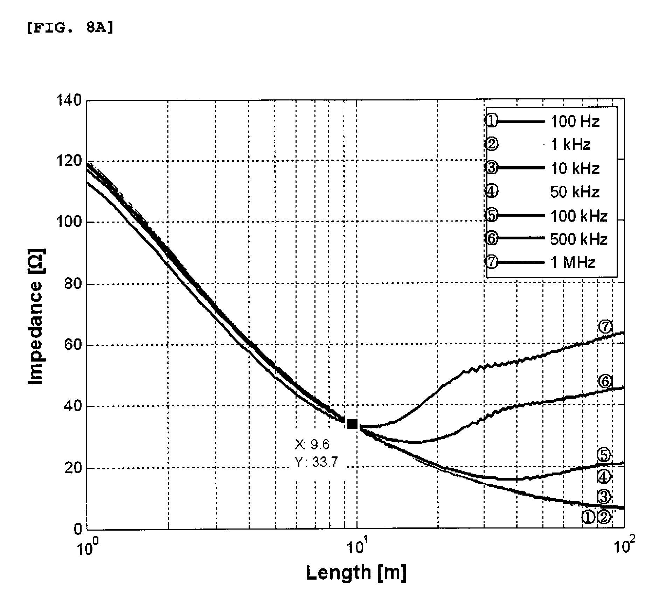

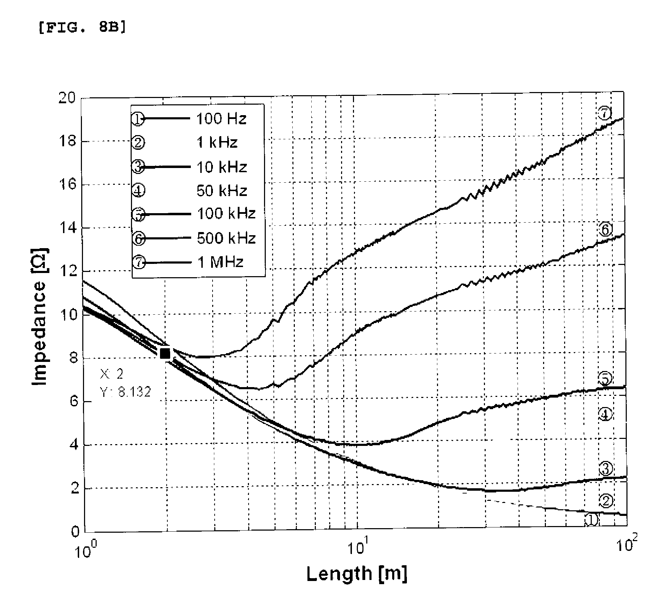

As the example described above, in the frequency range of 100 Hz to 1 MHz, the grounding impedance at a specific frequency depending on the increase in the length of the coaxial carbon grounding electrode module is simulated. FIG. 8 shows the simulation results of grounding impedances of a carbon grounding electrode module under conditions where the ground resistivity is relatively high of 280 Ωm and the relative dielectric constant is 20 and where the ground resistivity is relatively low of 23 Ωm and the relative dielectric constant is 20.

In the case where the length of the coaxial carbon grounding electrode module is short and the ground resistivity is high, the capacitive grounding impedance was found, and thus the grounding impedance was lower than the grounding resistance at high frequency and, when in the case where the length of the coaxial carbon grounding electrode module increased, the effect of the inductance in the grounding electrode increased, causing the inductive grounding impedance in which the grounding impedance was greater than the grounding resistance.

Accordingly, it is possible to calculate the length of the grounding electrode module at which the impedance variation range depending of the frequency is the smallest while the capacitive grounding impedance is change to the conductive impedance as the length of the carbon grounding electrode module increases.

That is, the grounding impedance variation is the smallest with a length of 9.6 m at a high ground resistivity in FIG. 8A and with a length of 2 m at a low ground resistivity in FIG. 8B, and the length is determined as an optimal design length at which the grounding impedance of the carbon grounding electrode module depending on the frequency is minimized.

The detailed method of obtaining the optimal length is as follows. The length of the grounding electrode module is divided by a unit length, and the grounding impedance at each frequency corresponding to each length of the grounding electrode module is obtained. This impedance value is the result value simulated by the simulation unit 34. Then, the difference between the maximum value and the minimum value of the obtained grounding impedance (i.e., the impedance variation range for each length) is obtained.

As such, the impedance variation range for each length with respect to each length of the grounding electrode module divided by the unit length is obtained. Then, the length at which the impedance variation range for each length is the smallest is determined as the optimal length of the grounding electrode module.

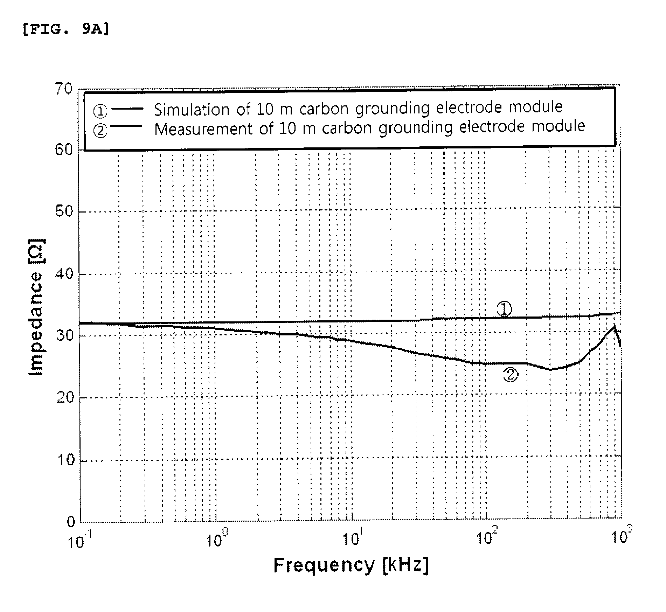

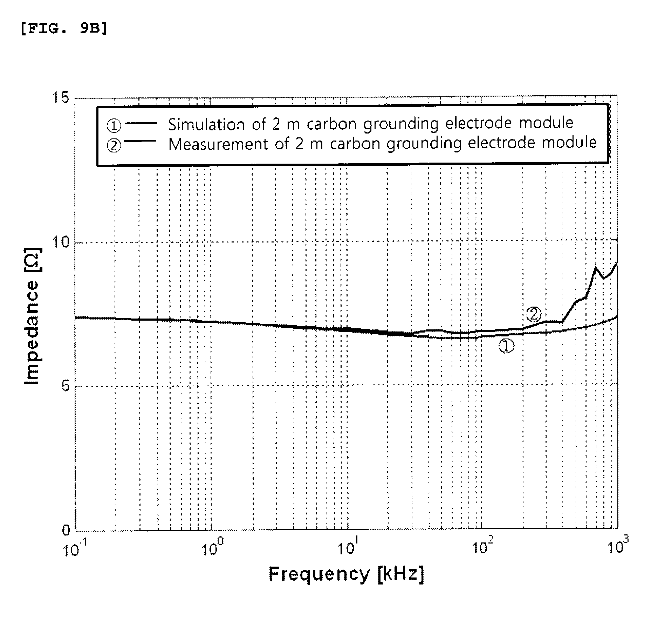

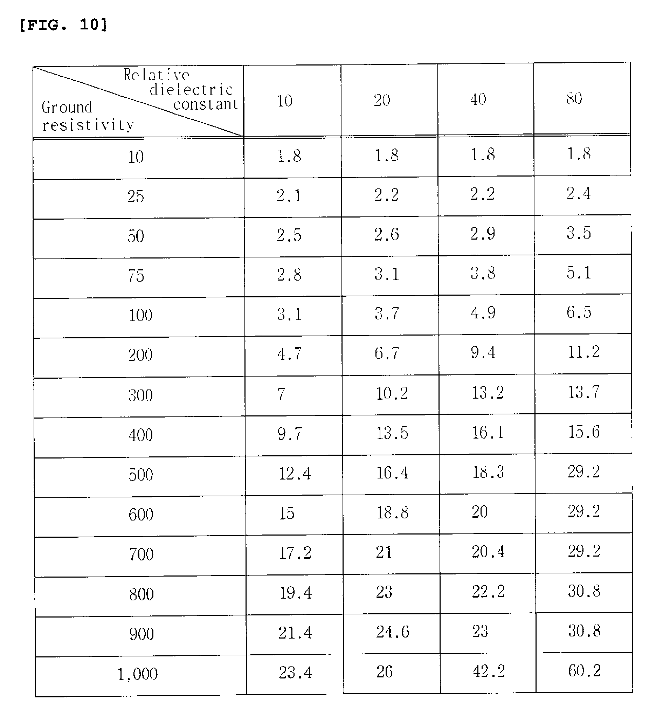

Next, the effects of the embodiment of the present invention will be described with reference to FIGS. 9 and 10.

In order to examine the Frequency variability with respect to the optical design length conditions of the carbon grounding electrode module obtained in FIG. 8, the frequency dependence for the grounding impedance of the carbon grounding electrode module in the soils having the same ground resistivity was simulated as shown in FIG. 9 and compared with the measurement results.

There are some differences between the simulation results and the measurement results in a high frequency region, which are considered as errors caused because the accurate relative dielectric constants of the soils are not reflected, from which it can be seen that the tendency of the grounding impedance depending on the frequency is very similar to the measurement results and the grounding impedance variation is small.

Accordingly, through the grounding impedance simulation of the carbon grounding electrode module performed in accordance with an embodiment of the present invention, it is possible to calculate the optimal design conditions of the carbon grounding electrode module with the smallest grounding impedance variation and obtain the reliability of the simulation results by the comparison with the measurement results.

It is known that the ground resistivity of soils is 10 to 1,000 $\Omega$m and the relative dielectric constant is 10 to 80, and thus when a critical length, at which the grounding impedance variation of the carbon grounding electrode module is the smallest, is calculated depending on the properties of each soil, it is possible to determine the optimal length of the carbon grounding electrode module.

FIG. 10 shows optimum design lengths of a coaxial carbon grounding electrode module with a minimum grounding impedance variation depending on the frequency, simulated with each distributed constant circuit depending on the resistivity and relative dielectric constant of the ground, and the calculation results are used as the criteria for the calculation of the optimal length of the carbon grounding electrode module.

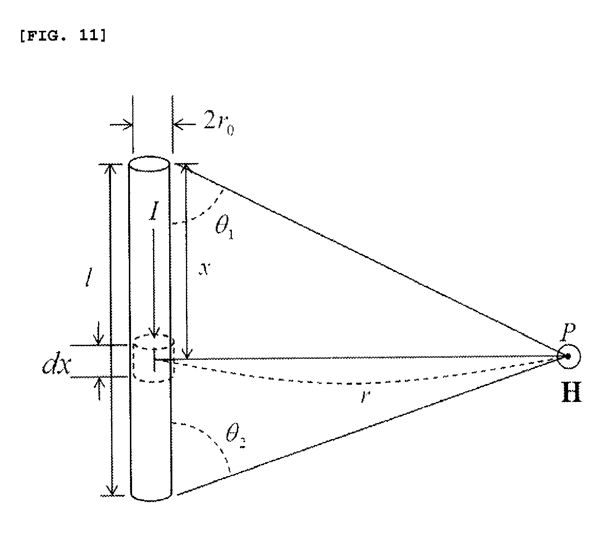

Next, the simulation in which the effect of the inductance of a grounding conductor (down-conductor) is contemplated in accordance with one embodiment of the present invention will be described with reference to FIGS. 11 to 13.

When the grounding impedance is measured to obtain measured results for the comparison with simulation analysis results, the grounding impedance is calculated by the measurement of the applied current and the potential of the grounding electrode. At this time, as well as the potential of the grounding electrode, a voltage drop of the grounding conductor is also included in the detected potential. When the inductance of the grounding conductor connected to the grounding electrode is 1 $\mu$, the grounding impedance is increased by 6.28 $\Omega$ by the grounding conductor at a frequency of 1 MHz and increased by 62.8 $\Omega$m at 10 MHz. Accordingly, the effect of the inductance of the grounding conductor cannot be ignored at high frequencies, and thus the inductance of the grounding conductor is calculated by the following method and applied to the simulation analysis of the grounding impedance.

The strength of a magnetic field generated by the current flowing through the grounding conductor of a finite length is calculated as shown in Equation 17 using the Biot-Savart law, and the total current flux linkage, linked with the conductor of a finite length, is calculated by Equation 18. The inductance depending on the diameter $2r_0$ and length 1 of the grounding conductor is calculated as shown in Equation 19 based on the calculated total current flux linage linked with the conductor.

[Equation 17]

$$H = \frac{I}{4\pi r}\left(\cos\theta_1 + \cos\theta_2\right)$$
$$= \frac{I}{4\pi r}\left(\frac{x}{\sqrt{r^2+x^2}} + \frac{l-x}{\sqrt{r^2+(l-x)^2}}\right)$$

[Equation 18]

$$\Psi = \int_{r_0}^{x}\int_0^l Id\Phi = \int_{r_0}^{x}\int_0^l IBdxdr = \int_{r_0}^{x}\int_0^l \mu_0 IHdxdr$$

[Equation 19]

$$L = \frac{\Psi}{I^2} = \frac{\mu_0}{4\pi}\int_0^l\left[\ln\left(\sqrt{\frac{1-\frac{x}{\sqrt{r_0^2+x^2}}}{1+\frac{x}{\sqrt{r_0^2+x^2}}}}\right) + \ln\left(\sqrt{\frac{1-\frac{l-x}{\sqrt{r_0^2+(l-x)^2}}}{1+\frac{l-x}{\sqrt{r_0^2+(l-x)^2}}}}\right)\right]dx$$

Here, $\mu_0$ represents the permeability of vacuum and 1 and $r_0$ represent the length and radius of the grounding conductor, respectively.

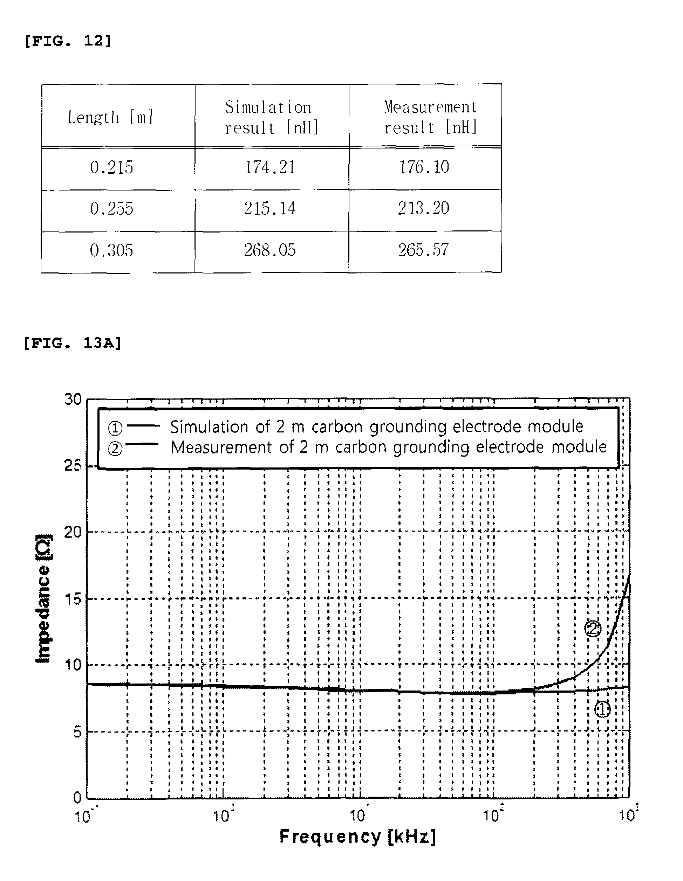

The grounding conductor connected to one end of a test grounding electrode is a GV wire having a cross-sectional area of 25 mm$^2$, and the simulation and measurement results of the inductance of the GV wire are as shown in FIG. 12.

The measurement was performed using an LCR meter. Moreover, since it is impossible to measure the inductance of a straight conductor having a length of 310 mm or greater under the conditions of the measurement equipment and the inductance varies depending on the type of conductor, the simulation and measurement results of the inductance of straight conductors of three different lengths in the measurable range are compared.

As data shown in FIG. 12, it can be seen that the simulation and measurement results have substantially the same values. Since the length of the grounding conductor connected to the coaxial carbon grounding electrode module actually installed is 1.2 m, the calculation result of the inductance on this is 1.38 $\mu$H, and this calculation result is serially added to a front end of the distributed constant circuit of the EMTP, thus reflecting the effect of the inductance of the grounding conductor during the simulation analysis.

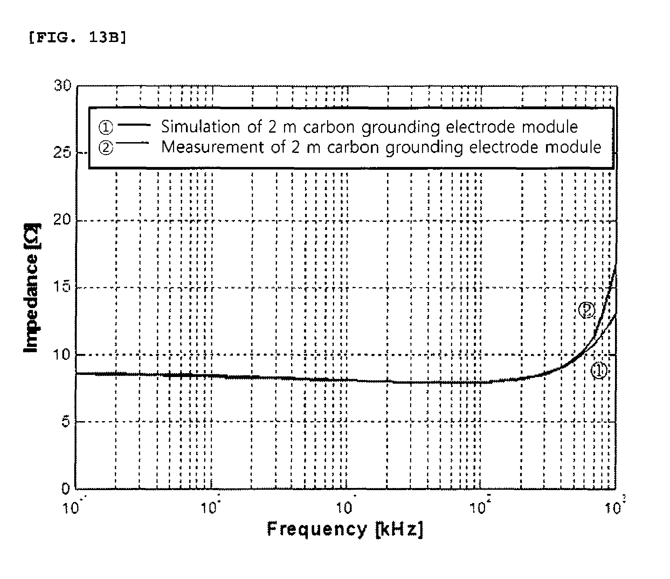

FIG. 13 shows the simulation results of the grounding impedance of the coaxial carbon grounding electrode module with and without the grounding conductor to verify the effect of the inductance of the grounding conductor, compared with the measurement values.

In FIG. 13A, the simulation results of a 2 m carbon grounding electrode module show that the effect of the inductance does not impedance is almost constant appear and the grounding impedance is almost constant even at frequency of 200 kHz or higher. However, the results measured under the same conditions show the inductive grounding impedance, in which the effect of the inductance is significant, at frequencies of 200 kHz or higher.

The simulation results of the grounding impedance in which the effect of the inductance of the grounding conductor at high frequencies is contemplated are shown in FIG. 13B. Compared with the results in which the effect of the grounding conductor is ignored, the simulation and measurement results are substantially the same. Accordingly, since the effect of the grounding conductor is significant on the grounding impedance and cannot be ignored at high frequencies, it is necessary to contemplate the effect of the grounding conductor during the simulation of the grounding impedance.

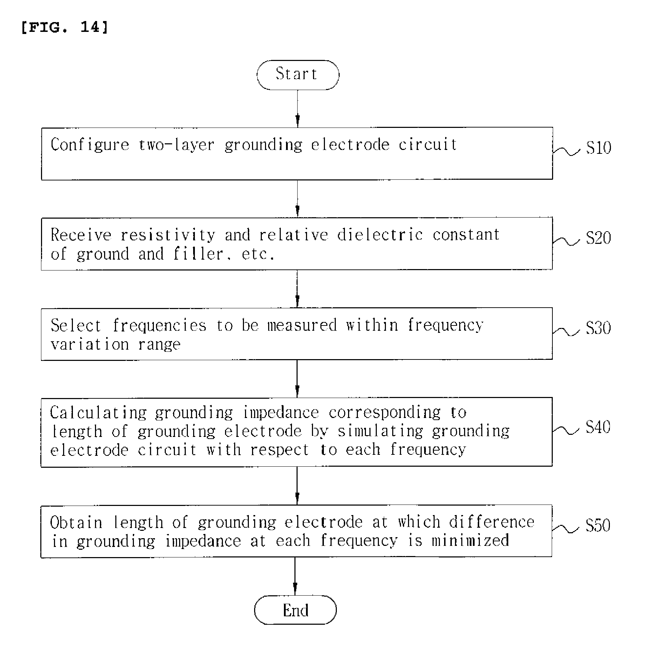

Next, a method for calculating a length of a carbon grounding electrode module in accordance with one embodiment of the present invention will be described with reference to FIG. 14.

As shown in FIG. 14, a method for calculating a length of a carbon grounding electrode module in accordance with one embodiment of the present invention comprises the steps of: (a) configuring a two-layered grounding electrode circuit with two distributed constant circuits (S10); (b) receiving resistivity and relative dielectric constant of ground, resistivity and relative dielectric constant of a filler, and internal and external diameters of the grounding electrode module as simulation parameters (S20); (c) selecting a plurality of frequencies within a frequency variation range (S30); (d) calculating a grounding impedance corresponding to a length of the grounding electrode by simulating the grounding electrode circuit with the simulation parameters with respect to each of the selected frequencies (S40); and (e) obtaining a length of the grounding electrode at which the difference between a maximum value and a minimum value of the grounding impedance at each frequency is minimized (S50).

For a more detailed description of the method for calculating the length of the carbon grounding electrode module, please refer to the description of the apparatus for calculating the length of the carbon grounding electrode module.

The embodiments of the present invention include a computer readable medium including program instructions for performing operations executed by various computers. The computer-readable medium may include program instructions, local data files, local data structures, or a combination thereof. The medium may be particularly designed and structured for the present invention or available to those skilled in computer software. Examples of computer-readable media include magnetic media, such as hard disks, floppy disks, and magnetic tape; optical media such as CD ROMs and DVDs; magneto-optical media, such as optical disks; and hardware devices that are specially configured to store and perform program instructions, such as read-only memory (ROM), random access memory (RAM), flash memory, and the like. Examples of program instructions include machine code, such as produced by a compiler, and files containing higher level code that may be executed by the computer using an interpreter.

The invention has been described in detail with reference to preferred embodiments thereof. However, it will be appreciated by those skilled in the art that changes may be made in these embodiments without departing from the principles and spirit of the invention, the scope of which is defined in the appended claims and their equivalents.

[Industrial Applicability]

The present invention is applicable to the calculation of the length of the carbon grounding electrode module, which has a coaxial structure and is filled with a carbon-containing filler, at which the variation of grounding impedance depending on frequency variation is minimized.

**Claims**

1.  An apparatus for calculating a length of a carbon grounding electrode module, which has a coaxial structure and is filled with a carbon-containing filler, at which the variation of grounding impedance depending on frequency variation is minimized, the apparatus comprising:

    a circuit configuration unit which configures a two-layered grounding electrode circuit with two distributed constant circuits;
    a parameter input unit which receives resistivity and relative dielectric constant of ground, resistivity and relative dielectric constant of a filler, and internal and external diameters of the grounding electrode module as simulation parameters;
    a frequency selection unit which selects a plurality of frequencies within a frequency variation range;
    a simulation unit which calculates a grounding impedance corresponding to a length of the grounding electrode by simulating the grounding electrode circuit with the simulation parameters with respect to each of the selected frequencies; and
    a grounding length estimation unit which obtains a length of the grounding electrode at which the difference between a maximum value and a minimum value of the grounding impedance at each frequency is minimized.

2.  The apparatus of claim 1, wherein the grounding electrode circuit is a two-layered grounding electrode circuit that comprises a lower distributed constant circuit using the resistivity and relative dielectric constant of the ground and an upper distributed constant circuit using the resistivity and relative dielectric constant of the filler.

3.  The apparatus of claim 2, wherein the two-layered grounding electrode circuit comprises $\mu$-type unit circuits in two layers, each of the $\mu$-type unit circuits configuring a parallel circuit of conductance G and capacitance C on both sides and connecting the parallel circuit on both sides to a circuit of inductance L.

4.  The apparatus of claim 3, wherein a first conductance $G_1$, a first capacitance $C_1$, and a first inductance $L_1$ of the upper distributed constant circuit and a second conductance $G_2$, a second capacitance $C_2$, and a second inductance $L_2$ of the lower distributed constant circuit are calculated during vertical burial by Equation 1:

[Equation 1]

$$G_1 = \frac{2\pi}{\rho_1 \ln\left(\frac{4l}{d_1}\right)} \quad [\text{U/m}]. \quad G_2 = \frac{2\pi}{\rho_2 \ln\left(\frac{4l}{d_2}\right)} \quad [\text{U/m}].$$

$$C_1 = \frac{2\pi\epsilon_1\epsilon_0}{\ln\left(\frac{4l}{d_1}\right)} \quad [\text{F/m}]. \quad C_2 = \frac{2\pi\epsilon_2\epsilon_0}{\ln\left(\frac{4l}{d_2}\right)} \quad [\text{F/m}].$$

$$L_1 = \frac{\mu_0}{2\pi} \ln\left(\frac{4l}{d_1}\right) \quad [\text{H/m}]. \quad L_2 = \frac{\mu_0}{2\pi} \ln\left(\frac{4l}{d_2}\right) \quad [\text{H/m}].$$

wherein 1, $d_1$, and $d_2$ represent the length, internal diameter, and external diameter of the grounding electrode module, respectively, $\rho_1$ and $\epsilon_1$ represent the resistivity and relative dielectric constant of a filler, respectively, $\rho_2$ and $\epsilon_2$ represent the resistivity and relative dielectric constant of ground, respectively, and $\epsilon_0$ and $\mu_0$ represent the permittivity and permeability of vacuum, respectively.

5.  The apparatus of claim 3, wherein a first conductance $G_1$, a first capacitance $C_1$, and a first inductance $L_1$ of the upper distributed constant circuit and a second conductance $G_2$, a second capacitance $C_2$, and a second inductance

$L_2$ of the lower distributed constant circuit are calculated during horizontal burial by Equation 2:

[Equation 2]

$$G_1 = \frac{\pi}{\rho_1} \frac{1}{\ln\left(\frac{2l}{\sqrt{2r_1 s}}\right) - 1} \ [\mho/m] , \quad G_2 = \frac{\pi}{\rho_2} \frac{1}{\ln\left(\frac{2l}{\sqrt{2r_2 s}}\right) - 1} \ [\mho/m] ,$$

$$C_1 = \frac{\pi \epsilon_1 \epsilon_0}{\ln\left(\frac{2l}{\sqrt{2r_1 s}}\right) - 1} \ [F/m] , \quad C_2 = \frac{\pi \epsilon_2 \epsilon_0}{\ln\left(\frac{2l}{\sqrt{2r_2 s}}\right) - 1} \ [F/m] ,$$

$$L_1 = \frac{\mu_0}{\pi} ln\left(\frac{2l}{\sqrt{2r_1 s}}\right) - 1 \ [H/m] , \quad L_2 = \frac{\mu_0}{\pi} ln\left(\frac{2l}{\sqrt{2r_2 s}}\right) - 1 \ [H/m] .$$

wherein 1, $d_1$, and $d_2$ represent the length, internal diameter, and external diameter of the grounding electrode module, respectively, $\rho_1$ and $\varepsilon_1$ represent the resistivity and relative dielectric constant of a filler, respectively, $\rho_2$ and $\varepsilon_2$ represent the resistivity and relative dielectric constant of ground, respectively, $\varepsilon_0$ and $\mu_0$ represent the permittivity and permeability of vacuum, respectively, and s represents the burial depth.

6. The apparatus of claim 1, wherein the simulation unit performs the simulation using an EMTP program.

7. The apparatus of claim 1, wherein the grounding length estimation unit divides the length of the grounding electrode module by a unit length, obtains a difference between a maximum value and a minimum value of the grounding impedance at each frequency corresponding to each length of the grounding electrode module (hereinafter, referred to as an impedance variation range for each length), and determines the length of the grounding electrode module at which the impedance variation range for each length is the smallest.

8. The apparatus of claim 1, wherein the grounding electrode circuit serially adds an inductance circuit of a grounding conductor (down-conductor) to a front end of the distributed constant circuit.

9. The apparatus of claim 1, wherein the inductance L of the inductance circuit of the grounding conductor is calculated by Equation 3:

[Equation 3]

$$L = \frac{\mu_0}{4\pi} \int_0^l \ln\left[\left(\sqrt{\frac{1 - \frac{x}{\sqrt{r_0^2 + x^2}}}{1 + \frac{x}{\sqrt{r_0^2 + x^2}}}}\right) + \ln\left(\sqrt{\frac{1 - \frac{l-x}{\sqrt{r_0^2 + (l-x)^2}}}{1 + \frac{l-x}{\sqrt{r_0^2 + (l-x)^2}}}}\right)\right] dx$$

wherein $\mu_0$ represents the permeability of vacuum and 1 and $r_0$ represent the length and radius of the grounding conductor, respectively.

10. A method for calculating a length of a carbon grounding electrode module, which has a coaxial structure and is filled with a carbon-containing filler, at which the variation of grounding impedance depending on frequency variation is minimized, the method comprising the steps of:

(a) configuring a two-layered grounding electrode circuit with two distributed constant circuits;
receiving resistivity and relative dielectric constant of ground, resistivity and relative dielectric constant of a filler, and internal and external diameters of the grounding electrode module as simulation parameters;
(c) selecting a plurality of frequencies within a frequency variation range;
(d) calculating a grounding impedance corresponding to a length of the grounding electrode by simulating the grounding electrode circuit with the simulation parameters with respect to each of the selected frequencies; and
(e) obtaining a length of the grounding electrode at which the difference between a maximum value and a minimum value of the grounding impedance at each frequency is minimized.

[FIG. 1]

[FIG. 2]

[FIG. 3A]

segment
with length $\Delta l$

$\rho$ : uniform

$I$

[FIG. 3B]

[FIG. 4]

(a)

(b)

(c)

[FIG. 5]

(a)                              (b)

[FIG. 6]

(a)

(b)

[FIG. 7]

[FIG. 8A]

[FIG. 8B]

[FIG. 9A]

[FIG. 9B]

[FIG. 10]

| Ground resistivity \ Relative dielectric constant | 10 | 20 | 40 | 80 |
|---|---|---|---|---|
| 10 | 1.8 | 1.8 | 1.8 | 1.8 |
| 25 | 2.1 | 2.2 | 2.2 | 2.4 |
| 50 | 2.5 | 2.6 | 2.9 | 3.5 |
| 75 | 2.8 | 3.1 | 3.8 | 5.1 |
| 100 | 3.1 | 3.7 | 4.9 | 6.5 |
| 200 | 4.7 | 6.7 | 9.4 | 11.2 |
| 300 | 7 | 10.2 | 13.2 | 13.7 |
| 400 | 9.7 | 13.5 | 16.1 | 15.6 |
| 500 | 12.4 | 16.4 | 18.3 | 29.2 |
| 600 | 15 | 18.8 | 20 | 29.2 |
| 700 | 17.2 | 21 | 20.4 | 29.2 |
| 800 | 19.4 | 23 | 22.2 | 30.8 |
| 900 | 21.4 | 24.6 | 23 | 30.8 |
| 1,000 | 23.4 | 26 | 42.2 | 60.2 |

[FIG. 11]

[FIG. 12]

| Length [m] | Simulation result [nH] | Measurement result [nH] |
|---|---|---|
| 0.215 | 174.21 | 176.10 |
| 0.255 | 215.14 | 213.20 |
| 0.305 | 268.05 | 265.57 |

[FIG. 13A]

[FIG. 13B]

[FIG. 14]

Start

Configure two-layer grounding electrode circuit — S10

Receive resistivity and relative dielectric constant of ground and filler, etc. — S20

Select frequencies to be measured within frequency variation range — S30

Calculating grounding impedance corresponding to length of grounding electrode by simulating grounding electrode circuit with respect to each frequency — S40

Obtain length of grounding electrode at which difference in grounding impedance at each frequency is minimized — S50

End